# EUROPEAN PATENT SPECIFICATION

(11) **EP 0 385 013 B1**
(45) Date of publication and mention of the grant of the patent: **16.06.1999**
(21) Application number: 89302180.8
(22) Date of filing: 03.03.1989
(51) Int. Cl.: G03F 7/24

(54) **Production of precision patterns on curved surfaces**
Herstellung von Präzisionsmustern auf gebogenen Oberflächen
Production de motifs de précision sur des surfaces courbes

(43) Date of publication of application: 05.09.1990
(73) Proprietor: TRW INC., Lyndhurst Ohio 44124 (US)
(72) Inventor: Haddock, Loren Bradley, Hermosa Beach California 90254 (US); Ballinger, Bruce Donald, Hermosa Beach California 90254 (US); Gelb, George Howard, Palos Verdes California 90274 (US)
(74) Representative: Allden, Thomas Stanley

(56) References cited:
- DE-A- 2 744 663
- FR-A- 2 245 984
- GB-A- 2 038 029
- GB-A- 2 150 312
- US-A- 3 620 623
- US-A- 3 694 080

## Description

### Field of the Invention.

This invention relates to a process for applying a complex pattern on a curved surface and, more particularly, to a process for forming a complex relatively thin conductive metal pattern, such as a dichroic pattern upon a curved or irregular three dimensional surface, such as a curved parabolic surface, useful as a dichroic reflector for high frequency RF propagation applications.

### Background.

Advanced communications satellites are to utilize millimeter wave RF frequencies for communications purposes. The antennas in those satellite communications systems are intended to be directional and thus alternatively provide spot and broad area coverage over selected geographic areas on earth. For this purpose the use of dichroic surfaces as reflectors and sub-reflectors is a primary means for obtaining in the antennas adequate RF channel separation and physical compactness desired in satellite applications. An existing process for producing dichroic RF reflecting surfaces is to apply a metalized dichroic pattern, a series of spaced dipoles, on a curved surface, such as a parabolic shaped surface, using an "segmented orange skin" approach; one in which the metal pattern is fabricated and then oriented over and stuck onto the parabolic surface in small pieces. This approach is time consuming and costly. Further, although useful at lower frequencies, at the higher millimeter wave frequencies, the process results in butt-joint discontinuities; mechanical protrusions in the surface that occur at the juncture of two separately cut metal pieces that are attached to the surface side by side. These discontinuities are unacceptable at millimetre wave frequencies, at which a quarter wavelength measures approximately 0,1875 cm (0.075 inches), because they effectively change the antennas radiation distribution pattern. In addition to antenna application, other applications exist in which precise metalization of non-planar or irregular three dimensional surfaces is required, such as with printed circuits that are to conform to irregular shapes and three dimensional RF strip lines, a form of microwave transmission line.

DE-A-2744663 discloses a method of transferring a flat rectangular design onto an arcuate surface such as a teacup, possibly via a flat image surface. It is possible to transfer a design from a flat transparency directly onto an arcuate surface but the original design is invariably distorted. Thus, the object of the invention of this disclosure is to reduce the distortion and various complex optical arrangements are disclosed to avoid foreshortening.

GB-A-2150312A discloses a method of forming a grid, for example for an electron microscope, the grid being shaped to conform to a hemispherical surface. A planar shadow mask is projected onto the grid via a fibre optic bundle which has a hemispherical end surface conforming to the shape of the grid blank, the grid blank being covered with a layer of photoresist. The usual etching techniques are used to form the desired holes in the grid according to the pattern of the shadow mask.

It is known from FR-A-2245984 to use automated processes for forming photolithographic masks for use in integrated circuit semiconductor chip design.

An object of the present invention is to provide a fast and effective process for fabricating complex intricate metal patterns on a non-planar curved surface. A secondary object is to provide a process for producing millimetre wave dichroic parabolic antenna reflector.

The present invention provides a method of fabricating a pattern on a curved three dimensional surface of a body to form a patterned surface, comprising coating the surface with a thin covering layer of material, such material having the characteristic of changing its physical state responsive to exposure to light; and transferring a two dimensional pattern onto the three dimensional surface by exposing the surface to light according to said pattern;
characterised by, prior to said transferring step:
generating a first computer model of the three dimensional image of the patterned surface and generating a second computer model of the two dimensional projection of the pattern from the first computer model as represents the projection of the said three dimensional image onto a planar surface, and said transferring step including:
scanning a collimated light source along a series of spaced parallel lines in and about a plane spaced from coated portions of the surface of said body, whereby some portions of said body are spaced from said light source at distances different from that by which other portions of said body are spaced from said light source, to expose said coated three dimensional surface underlying said plane to light in the negative image of the pattern defined by said second computer model, such that said three dimensional surface, when exposed to said light, becomes excited and undergoes a change in its physical state.

The computer model is preferably converted to a second media, a two dimensional media, such as by way of example, a photo resist mask or a series of photo resist masks or a control tape for a numerically controlled machine, such as a numerically controlled optical machine. The source of collimated light may be used to create the pattern on the curved surface by scanning the light over the surface under control of the tape driven machine. In one possible aspect of this process the mark is oriented overlying and in register with the curved photo resist coated surface and the source of collimated light is directed through and scanned over the mask pattern, whereby portions of the underlying photo resist coated surface, is exposed to the light in the shadow or negative image of the pattern contained on the mask, changing the properties of the exposed portion of the photoresist coating.

In a further aspect of the process, the computer model may be used to create a tape for a numerically controlled machine and the numerically controlled machine carries as the light source a high power cutting laser. The laser is used to vaporize or cut away portions of the copper cladding on a copper clad surface, leaving in place on that surface the configuration or patterns specified by the numerically controlled machine tape. In a still further example, a photo chemically coated curved metal plated insulator surface is machined using an activating collimated light source, suitably ultraviolet light, that is scanned over the surface, exposing those particular areas of the photosensitive coating in a pattern defined by the data base information contained on the controlled machines tape, the tape having been created in the earlier described manner; whereby the exposed areas of coating are transformed from a normal to a semi-hardened characteristic. The surface is then treated in any known manner to remove the unexposed portions of the photosensitive coating, exposing underlying portions of the metal plating. The surface is then placed in a metal etchant to remove the exposed metal, while the semi-hardened layer protects the remaining underlying metal. The semi-hardened coating is then removed to provide the surface containing the desired metal pattern.

The foregoing and additional objects and advantages of the invention together with the structure characteristic thereof, which was only briefly summarized in the foregoing passages, becomes more apparent to those skilled in the art upon reading the detailed description of a preferred embodiment, which follows in this specification, taken together with the illustration thereof presented in the accompanying drawings.

### Brief Description of the Drawings.

In the drawings:
Figure 1 illustrates the process in flow chart form;
Figure 2 illustrates a step in the process and the accompanying apparatus for defining patterns on the curved surface;
Figure 2a is a partial view of a portion of figure 2;
Figure 2b illustrates an alternative fixture to that of figure 1;
Figures 3 and 4 illustrate alternative apparatus used in the process for applying the patterns to a curved surface;
Figure 5 illustrates the shape of a dichroic reflector;
Figure 5a is an enlarged view of an end portion of the reflector of figure 5;
Figure 5b illustrates a dichroic element in enlarged view; and
Figure 5c illustrates the spacing between elements as are formed according to the process.

### Detailed Description.

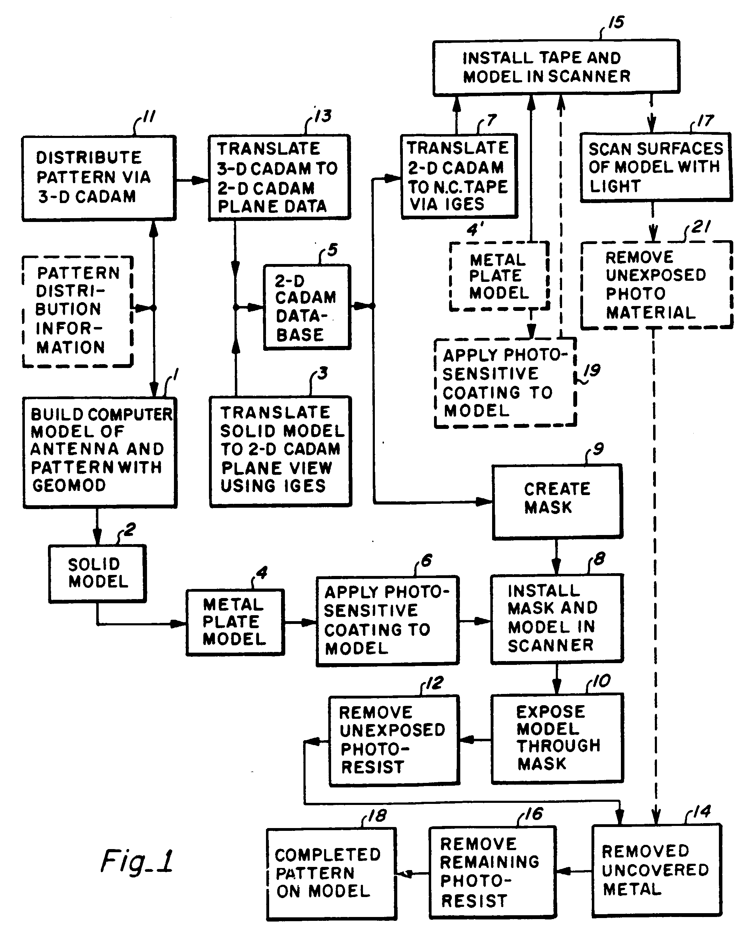

As represented in block 1 in Figure 1, a computer model of the curved surface and the pattern intended to be formed on that surface is generated on a convention computer graphics display using any of the well known computer graphic programs, such as the "GEOMOD" brand program. The surface is constructed in three dimensional solid form, using the results of the computer model, as represented in block 2, or, alternatively, the data is translated into another database as represented in block 3. The "Geomod" program is one that is distributed by Structural Dynamics Research Corp. of San Diego, California. It is a software program which allows an engineer to design hardware on a computer with the design appearing as a solid geometry in free space. These graphic design programs are well known in the art of computer graphics. Likewise the associated computers, such as Apollo, Digital Equipment Corp., IBM, Sun, and H-P computers, and displays which use the "GEOMOD" program are also well known in the computer graphics art to which the reader may make reference if desired.

Using the foregoing apparatus, the curved surface and the pattern are effectively "built" on the computer with all appropriate dimensions and proportions being given. Fabricators blueprints for the surface are printed out on a conventional plotter and given to a model maker, who may build the surface. The surface is then treated as herein described.

As represented in block 3, the three dimensional computer generated model or simulation of the pattern is then translated to a two dimensional plan view, which represents the pattern as viewed from the top side in a single plane by way of example. This is accomplished using another well known standard translator "IGES". IGES stands for Initial Graphics Exchange System. It is a standard developed jointly by industry to transfer the data bases created using one program, such as "CADAM" to a form usable by another program, such as "GEOMOD". The "IGES" program takes the data and generates a two dimensional "CADAM" data base.

The "CADAM" graphics program is a well known computer graphics program. It is distributed by CADAM, Inc. of Burbank, California. "CADAM" may be regarded as an acronym for computer aided design and manufacturing. The software program lets the engineer or draftsman perform design or drafting on a computer. Usually it is run on a IBM computer. Its data base may be used for many purposes. In the application of this process, the "CADAM" data base contains the representation in digital form of the complex patterns as viewed in a two dimensional plane, specifically from the top side in the example given. As represented at block 5 in figure 1, the data base is then translated into the form of a numerically controlled tape as represented in block 7, such as by use of the IGES standard referred to previously or, alternately the database is supplied to a plotter as represented in block 9.

As those skilled in the art recognize, the form of the information contained in the data base must be translated into a form that is specified by the manufacturer of numerically controlled tape inputted milling machines which are available in the industry. This translation or conversion program is well known to those who use that equipment. The tape is then used to control the milling machine which carries out further steps in the process as is hereinafter described.

Alternatively the "Cadam" data base is translated into a two dimensional plotter pattern on a photographic mask. This is accomplished by using a conventional precision graphic plotter represented in block 9, such as the Gerber Plotter, known in the industry. The Gerber Plotter is a z-axis (x,y) processor controlled photo plotter made by the Gerber Corporation. It is used to make precision photo masks for printed circuit board manufacture using data supplied by a computer database, such as the "Cadam" program. It incorporates software, a computer program made available from Gerber for that purpose. The Gerber Plotter takes "Cadam" information directly and fabricates a photographic mask. The resulting mask used by the additional apparatus to carry out further steps in the process as is hereinafter described in more detail.

An alternative technique for creating the two dimensional pattern data base is also represented in figure 1. The pattern to be applied is contained as three dimensional "Cadam" data as represented by block 11. This data is stored in the form used by that known program. As previously described a principal use of the "Cadam" program is to allow a three dimensional object to be viewed from many angles, hence the object may be made to appear to rotate in position on the computer display terminal allowing the equipment designer to view the part from many angles. Each view is in essence the projection of the three dimensional part upon a two dimensional plane. As represented in block 13, the three dimensional pattern data is translated or converted from three dimensional form to a two dimensional "Cadam" data base. As in the prior example, this 2-D "Cadam" data base represented at block 5 may be further converted to the numerically controlled tape form, such as represented in block 7, and alternatively into the form used by the Gerber Plotter through use of the IGES standard conversion, described earlier, to generate a photo mask pattern as represented in the block 9. As those familiar with the high resolution capabilities of computer aided graphics generation recognize, the generation of the complex patterns and its translation or conversion to other forms of data base provides an effective and rapid means for generating and handling highly complex patterns containing minute elements in those patterns, such as the dichroic dipoles referred to for use in millimeter wave reflectors.

The solid non-metallic model or surface on which a conductive pattern is to be formed is "metalized" or plated with a thin layer of the desired metal, such as copper or gold. One preferred known technique for so plating the surface is a metal deposition process. In this process the surface is placed in a vacuum chamber, which contains a heater and the plating metal. The chamber is evacuated and the heating elements are operated to vaporize the metal. The vaporized metal in the vacuum is diffused and deposits upon the surface forming a strong bonded metal coating. Thereafter a photosensitive coating is applied over the metal layer in a conventional manner. The coating may be the light sensitive polymer applied as a film or spray familiar to those in the printed circuit board art and often referred to as a photoresist, a 0.38 mm (1.5 mil) film of "DuPont Riston" (trade mark) film is an example.

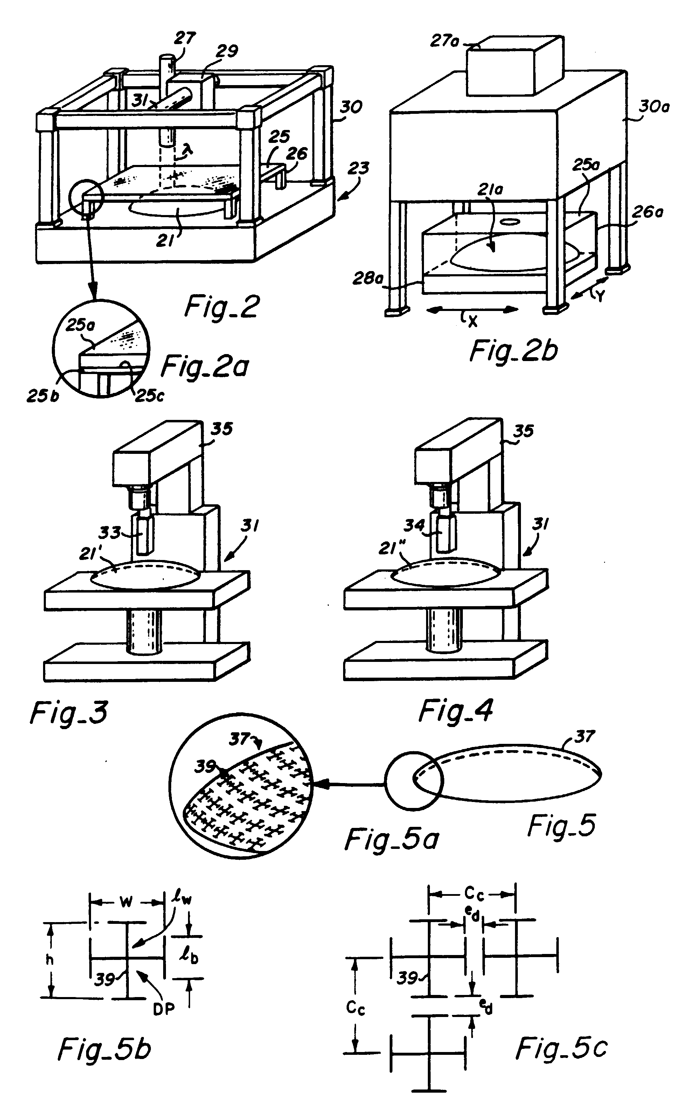

As represented in figure 2, surface 21 is placed within an automated measuring device 23 in a position underlying the photo mask assembly 25. This photomask contains the pattern, more appropriately a negative image of the pattern, and was produced by the steps described in figure 1. As illustrated in figure 2d, the mask assembly consists of optical glass plates 25a and 25b with the mask pattern 25c sandwiched in between. Suitably the mask assembly contains appropriate registration marks so that the mask is accurately oriented over the target surface 21. Automated measuring device 23 contains a collimated ultraviolet light source 27 which is carried by a positioning element 29 of the measuring device. Suitably the light source is a shaped beam of light in the ultraviolet frequencies having an axial spread no greater than one and one half degrees off axis. Other sources of collimated light may be substituted, such as a laser.

Positioning element 29 of the measuring device is controlled to move laterally along the cylindrical guide bar 31. In turn, the bar 31 can move to the left and to the right in the fixture. This movement is controlled by conventional control circuits within the measuring device, not illustrated in the figure and that are not necessary to an understanding of the invention. This device is programmed so that the ultraviolet light source is scanned across the mask starting from one end to the other end and then down, line by line. Those portions of the mask containing the pattern obstruct the light; whereas the open portions of the mask allow the light to shine through and expose the underlying portion of the photo sensitive coating on shaped surface 21. The coating material on the shaped surface 21 undergoes a change in its physical state in response to the exposure to light. For purposes of this application, the expression "exposure to light" means exposing the surface of a material to a light source, such that the surface of the material is excited and such that the energy from that light source causes a change in the physical properties or state of the surface on which the light energy hits. In the present application, the expression "exposure to light" may encompass, but is not limited to, such light sources as ultraviolet light or high intensity laser light. In one embodiment, the surface of a photoresist material may be exposed to ultraviolet light, which causes a physical change or chemical reaction to occur at the area on the surface where the ultraviolet light hits, such that when the surface is subsequently treated with a solvent, as further described below, the solvent preferentially strips away the areas on the surface that have been exposed or not exposed, thus leaving a pattern. In another embodiment, as further described below, the surface of a material may be exposed to high intensity laser light, wherein the laser light exposure causes a change in the physical state of the surface, such as a cutting away, melting or vaporizing of the surface of the material.

Alternatively, an apparatus for exposing the photomask may be of a type in which the source of ultraviolet light is held stationary and the mask and surface are supported on a movable (x, y) table such as is pictorially illustrated in figure 2b.

As those skilled in the photo etching appreciate, upon completion of the process, the exposed portions of the photo sensitive coating are in effect cured or hardened. Surface 21 is then treated to remove away the unexposed portions underlying metal leaving the metal pattern defined by the exposed portion of the photoresist. This is represented further in figure 1 to which reference is again made. As represented in block 4, the model is metal plated, the photoresist coating is applied as presented in block 6, the mask and model are installed and scanned as earlier described as represented in blocks 8 and 10, respectively, and the photoresist is removed as in block 12.

The surface is immersed in a "wash" chemical, suitably 1,1,1 Trichloroethane ("TCE"), and the non-hardened portions of the photoresist are removed, exposing the underlying metal plating. The surface is then immersed in a metal etchant solution, such as a strong acid, chromic acid, if the plating is copper, and the exposed copper is removed as represented by block 14. The semi-hardened photoresist overlying other portions of the plating is essentially immune to the acid etchant and protects the underlying portions of the metal layer. The surface is then placed in a bath of the liquid wash, also suitably 1,1,1 Trichloroethane, and the bath is ultrasonically agitated to remove the hardened portion of the photoresist as represented in block 16, exposing the remaining metal, which is in the desired pattern as represented at block 18.

The exact details of time, temperature, and concentration will vary according to many factors, including the thickness and quality of the coated materials. The factors and details are well known to those skilled in the printed circuit board and plating arts and need not be described further.

An alternative that is essentially "maskless" derives through the steps leading through the plating of the model or surface as at 4' and the creation of the control tape as at block 7; and the installation in the scanner as at block 15. This is followed by scanning as represented by block 17. The scanning may be a cutting laser. As pictorially depicted in figure 3 to which reference is made, the surface 21', which in this instance is clad or coated with a metal, such as copper, is placed on the table of a numerically controlled milling machine 31, pictorially partially illustrated in this figure. The milling machine supports a cutting laser 33 which is mounted to a positioning arm 35, the details of which are not important to the understanding of the invention and are well known to those in the numerically controlled milling machine arts. In as much as the milling machine is controlled by the information contained on the tape. As previously described, the tape contains the geometrical planar information of the pattern. Accordingly in operation of the milling machine, the laser is positioned to or scans all areas of the surface in the negative of the image of the desired patterns. The laser generates intense light bursts that cut or etch away the copper cladding, exposing the underlying insulative surface. Upon completion of the milling operation, the remaining copper cladding is in the form of the desired pattern.

An alternative to the laser cutting or etching or a copper clad surface in the steps presented in figure 3 also uses the numerically controlled machine. Reference is again made to the flow chart of figure 1 for this additional alternative. The metal coated model represented by block 4' is covered with a photoresist as represented at 19 and the model and numerically controlled tape are installed in the scanner as at block 15.

The milling machine presented in figure 4 contains a photo active light source, such as ultraviolet light. Target surface 21" in this figure is a metalized insulator that further contains a photosensitive chemical coating, such as a photoresist described earlier, the same as surface 21 described in figure 2. The photo chemical coating is such that the exposure to the laser's light hardens the areas exposed to the light. The laser is driven to and generates light on portion of the surfaces in the negative of the pattern contained in the numerically controlled tape governing the operation of the milling machine. Upon completion of the operation using the equipment of figure 4, the curved surface 21" in the same manner described provides the metal pattern on surface as was accomplished and described in connection with the apparatus of figure 2. This is represented further in figure 1 by the removal of the unexposed photoresist as at block 21, the removal of the uncovered metal at block 14, the removal of the remaining photoresist at block 16 and the resulting pattern on model at block 18.

As those skilled in the art recognize, the surface used in the preceding examples is a gradually sloped parabolic or hemispherical surface. The conductor pattern on the surface when projected into a two dimensional frame contains very little distortion. As the sides of the curved surface have a deeper slope, the distortion becomes greater, hence an addition to the process steps illustrated in figure 2 is desirable. In that instance a series of photo masks may be generated and used. In the area of greater slope a photograph or photo mask in the form of a ring or annulus may be generated to fit over a portion of the surface. In that instance the annular mask contains only a portion of the overall pattern. The ultraviolet light is used to expose that portion of the surface underlying the annular shaped mask. Suitably a series of such ring shaped masks are produced which are contiguous with one another with the central mask being circular so that each section defines a small portion of the overall pattern. Because the ring shaped mask may be placed closer to the photo conductively treated areas of the target surface, the distortion is less.

A parabolic dichroic antenna reflector 37 made according to the process is illustrated in figure 5 and a portion of that reflector is shown to enlarged scale in figure 5a revealing the pattern of small regularly spaced metal antenna elements 39 referred to as cross dipoles or "Jerusalem crosses". As illustrated to a greatly enlarged scale, at frequencies on the order of 40 to 44 GigaHertz each dipole is of a dimension of 32 mm (0.1265 inches) width, w, and heighth, h, and has the end cap ends approximately 15 mm (0.060 inches) in length, lb. The line width, lw, is 0.005 inches. As presented in figure 5c, center to center adjacent dipoles, Cc, are spaced 0.134 inches apart and end to end, ed, are spaced 3.8 mm (0.015 inches).

The reflector serves as a filter that reflects RF signals in the 40-44 GHz frequency range. The 32 mm (0.1265 inch) end bar functions as quarter wave length resonator and the 3.8 mm (0.015 inch) spacing between end bars defines a capacitance that determines RF cross coupling between adjacent dipoles, affecting the bandwidth of filtering.

The foregoing example of an antenna constructed according to the novel technique attests to the utility of the process.

It is believed that the foregoing description of the preferred embodiments of the invention is sufficient in detail to enable one skilled in the art to practice the invention. However, it is expressly understood that the details of the steps and elements, which are presented for the foregoing enabling purpose, are not intended to limit the scope of the invention, in as much as equivalents to those steps and elements and other modifications thereto, all of which come within the scope of the invention, become apparent to those skilled in the art upon reading this specification. Thus the invention is to be broadly construed within the full scope of the appended claims.

## Claims

1. A method of fabricating a pattern on a curved three dimensional surface (21) of a body to form a patterned surface, comprising coating the surface (21) with a thin covering layer of material, such material having the characteristic of changing its physical state responsive to exposure to light; and transferring a two dimensional pattern onto the three dimensional surface by exposing the surface to light according to said pattern;
characterized by, prior to said transferring step:
generating a first computer model of the three dimensional image of the patterned surface and generating a second computer model of the two dimensional projection of the pattern from the first computer model as represents the projection of [the] said three dimensional image onto a planar surface, and said transferring step including:
scanning a collimated light source (27, 33) along a series of spaced parallel lines in and about a plane spaced from coated portions of the surface of said body, whereby some portions of said body are spaced from said light source (27, 33) at distances different from that by which other portions of said body are spaced from said light source, to expose said coated three dimensional surface (21) underlying said plane to light in the negative image of the pattern defined by said second computer model, such that said three dimensional surface, when exposed to said light, becomes excited and undergoes a change in its physical state.

2. A method as defined in claim 1, characterized by the body being formed from a first material covered by a layer of a second dissimilar material on the surface to which the pattern is to be applied, said thin covering layer being applied over said second material, and wherein said thin covering layer comprises a light sensitive coating.

3. A method as claimed in claim 2 in which the first material is an electrical insulator and the second material is a metal.

4. The method as defined in claim 2 further comprising the steps prior to scanning of: translating the computer model into a two dimensional pattern on a photographic mask (25) and positioning the three dimensional surface underlying the photographic mask in registry with the pattern contained on said mask; whereby scanning said mask with said source of collimated light (27) exposes the light-sensitive coating on said surface in the negative image of the pattern contained on said mask, and wherein the method further comprises the steps of: removing the unexposed portions of said light-sensitive coating to uncover portions of the second material; and etching the portions of the surface with an etchant that removes said second material to expose said first material without removing said remaining light-sensitive coating; and followed by removing said remaining light-sensitive material.

5. The invention as defined in claim 4 wherein said light-sensitive material comprises a photoresist.

6. The method as defined in claim 2 further comprising the additional steps prior to scanning of: translating said computer model into a numerically controlled tape control media for a controlled milling machine (31); and controlling the scanning of said light source (33) through pattern information contained on said milling machine tape control media to expose said target surface in the negative image of the pattern defined by said milling machine tape control media; and further comprising the additional steps of: removing the unexposed portions of said light-sensitive coating from said surface (21) to expose the underlying material, and etching the exposed portions of the surface from which said light-sensitive coating was removed with a metal etchant to remove the underlying second material and expose the first material and removing the remaining light-sensitive coating.

7. The method as defined in claim 1 further comprising the steps prior to scanning of: translating the pattern information as contained in said two dimensional computer model into the form of a numerical controlled milling machine control tape; and placing the surface within the milling machine (31); and wherein the step of scanning includes applying high intensity light capable (33) of vaporizing metal to vaporize areas of said metal cladding in the negative of the image of the pattern as represented by information contained on the milling machine tape.

8. The method of manufacturing a dichroic RF reflecting surface (37) of the type containing an array of thin flat metal cross dipole radiating elements (39) of substantially identical size and shape evenly spaced about and affixed to the convex parabolic shaped surface of an electrical insulator material from a body of insular material having a convex parabolic shaped surface which comprises the steps of any preceding claim.

## Patentansprüche

1. Verfahren zur Herstellung einer Struktur auf einer gekrümmten dreidimensionalen Oberfläche (21) eines Körpers, um eine strukturierte Oberfläche herzustellen, mit Beschichten der Oberfläche (21) mit einer dünnen Deckschicht eines Materials, wobei ein derartiges Material die Eigenschaft aufweist, seinen physikalischen Zustand als Reaktion auf eine Belichtung zu ändern, und Übertragen einer zweidimensionalen Struktur auf die dreidimensionale Oberfläche, indem die Oberfläche gemäß der Struktur belichtet wird,
gekennzeichnet durch dem Übertragungsschritt vorausgehendes:
Erzeugen eines ersten Computermodells des dreidimensionalen Bildes der strukturierten Oberfläche, und Erzeugen eines zweiten Computermodells der zweidimensionalen Projektion der Struktur von dem ersten Computermodell, wie es die Projektion des dreidimensionalen Bildes auf eine ebene Oberfläche wiedergibt, und wobei der Übertragungsschritt umfaßt:
Ablenken einer Quelle (27, 33) parallelen Lichts entlang eine Reihe parallel beabstandeter Linien in und um einer Ebene, die von beschichteten Bereichen der Oberfläche des Körpers beabstandet angeordnet ist, wobei einige Bereiche des Körpers von der Lichtquelle (27, 33) in Abständen beabstandet sind, die sich von denen unterscheiden, in denen andere Bereiche des Körpers von der Lichtquelle beabstandet sind, um die beschichtete, unter der Ebene liegende dreidimensionale Oberfläche (21) in dem Negativbild der von dem zweiten Computermodell definierten Struktur zu belichten, so daß die dreidimensionale Oberfläche angeregt wird und eine Änderung ihres physikalischen Zustandes vollzieht, wenn sie belichtet wird.

2. Verfahren nach Anspruch 1, dadurch gekennzeichnet, daß der Körper aus einem ersten Material gebildet wird, das von einer Schicht eines zweiten von diesem abweichenden Materials auf der Oberfläche bedeckt wird, auf die die Struktur aufgetragen werden soll, wobei die dünne Deckschicht über dem zweiten Material aufgetragen wird, und bei dem die dünne Deckschicht eine lichtempfindliche Beschichtung umfaßt.

3. Verfahren nach Anspruch 2, bei dem das erste Material ein elektrischer Isolator und das zweite Material ein Metall ist.

4. Verfahren nach Anspruch 2, des weiteren die dem Ablenken vorausgehenden Schritte umfassend: Umsetzen des Computermodells in eine zweidimensionale Struktur auf einer photographischen Maske (25), und Anordnen der unter der photographischen Maske liegenden dreidimensionalen Oberfläche in Überdeckung mit der auf der Maske enthaltenen Struktur, wobei ein Abtasten der Maske mit der Quelle (27) parallelen Lichts die lichtempfindliche Beschichtung auf der Oberfläche in dem Negativbild der auf der Maske enthaltenen Struktur freilegt, und bei dem das Verfahren des weiteren die Schritte umfaßt: Entfernen der nicht freigelegten Bereiche der lichtempfindlichen Beschichtung, um Bereiche des zweiten Materials freizulegen, und Ätzen der Bereiche der Oberfläche mit einem Ätzmittel, das das zweite Material entfernt, um das erste Material ohne Entfernen der verbliebenen lichtempfindlichen Beschichtung freizulegen, und gefolgt von Entfernen des verbliebenen lichtempfindlichen Materials.

5. Verfahren gemäß Anspruch 4, bei dem das lichtempfindliche Material einen Photolack umfaßt.

6. Verfahren nach Anspruch 2, des weiteren die zusätzlichen, dem Ablenken vorausgehenden Schritte umfassend: Umsetzen des Computermodells auf einen Datenträger einer numerisch gesteuerten Bandsteuerung für eine gesteuerte Fräsmaschine (31), und Steuern des Ablenkens der Lichtquelle (33) durch Strukturinformationen, die auf dem Datenträger zur Fräsmaschinenbandsteuerung enthalten sind, um die Zieloberfläche in dem Negativbild der von dem Datenträger zur Fräsmaschinenbandsteuerung definierten Struktur freizulegen, und des weiteren die zusätzlichen Schritte umfassend: Entfernen der nicht freigelegten Bereiche der lichtempfindlichen Beschichtung von der Oberfläche (21), um das darunterliegende Material freizulegen, und Ätzen der freigelegten Bereiche der Oberfläche, von der die lichtempfindliche Beschichtung mit einem Metallätzmittel entfernt wurde, um das darunterliegende zweite Material zu entfernen und das erste Material freizulegen und die verbliebene lichtempfindliche Beschichtung zu entfernen.

7. Verfahren nach Anspruch 1, des weiteren die dem Abtasten vorausgehenden Schritte umfassend: Umsetzen der Strukturinformationen, wie sie in dem zweidimensionalen Computermodell enthalten sind, in die Form eines Bandes für eine numerisch gesteuerte Fräsmaschinensteuerung, und Anordnen der Oberfläche in der Fräsmaschine (31), und wobei der Abtastschritt ein Anwenden eines sehr intensiven Lichts (33) umfaßt, das Metall verdampfen kann, um Bereiche der Metallummantelung in dem Negativ des Bildes der Struktur zu verdampfen, wie sie von der auf dem Fräsmaschinenband enthaltenen Information wiedergegeben ist.

8. Verfahren zur Herstellung einer dichroitischen RF-reflektierenden Oberfläche (37) von dem Typ, der eine Anordnung dünner flacher abstrahlender Metallelemente (39) für Kreuzdipole von im wesentlichen identischer Größe und Gestalt aufweist, die über der konvexen parabolisch geformten Oberfläche eines elektrischen Isoliermaterials eines Körpers aus Isoliermaterial, der eine konvexe parabolisch geformte Oberfläche aufweist, gleichmäßig beabstandet und an dieser befestigt sind, das die Schritte eines der vorhergehenden Ansprüche aufweist.

## Revendications

1. Procédé de fabrication d'un motif sur une surface tridimensionnelle courbe (21) d'un corps pour former une surface formée en motif, comprenant l'enduction de la surface (21) avec une mince couche de couverture de matériau, ce matériau ayant la caractéristique de changer son état physique en réponse à l'exposition à la lumière, et le transfert d'un motif bidimensionnel sur la surface tridimensionnelle en exposant la surface à la lumière selon ledit motif ;
caractérisé par, avant ladite étape de transfert :
la génération d'un premier modèle d'ordinateur de l'image tridimensionnelle de la surface formée en motif et la génération d'un second modèle d'ordinateur de la projection bidimensionnelle du motif à partir du premier modèle d'ordinateur comme le représente la projection de ladite image tridimensionnelle sur une surface planar, et ladite étape de transfert comprenant :
le balayage d'une source lumineuse collimatée (27, 33) le long d'une série de ligne parallèle espacée dans et autour d'un plan espacé des parties enduites de la surface dudit corps, de sorte que certaines parties dudit corps sont espacées de ladite source lumineuse (27, 33) à des distances différentes de celles par lesquelles d'autres parties dudit corps sont espacées de ladite source lumineuse, pour exposer ladite surface tridimensionnelle enduite (21) sous ledit plan, à la lumière dans l'image négative du motif défini par ledit second modèle d'ordinateur, pour que ladite surface tridimensionnelle, lorsqu'elle est exposée à ladite lumière, devienne excitée et subisse un changement dans son état physique.

2. Procédé tel que défini dans la revendication 1, caractérisé en ce que le corps est formé à partir d'un premier matériau couvert par une couche d'un second matériau dissemblable sur la surface duquel le motif est à appliquer, ladite mince couche de couverture étant appliquée sur ledit second matériau, et où ladite mince couche de couverture comprend un revêtement sensible à la lumière.

3. Procédé selon la revendication 2, dans lequel le premier matériau est un isolant électrique et le second matériau est un métal.

4. Procédé selon la revendication 2 comprenant en outre les étapes avant le balayage de : traduction du modèle d'ordinateur en un motif bidimensionnel sur un masque photographique (25) et positionnement de la surface tridimensionnelle sous le masque photographique en registre avec un motif contenu sur ledit masque, de sorte que le balayage avec ladite source de la lumière collimatée (27) expose le revêtement sensible à la lumière sur ladite surface dans l'image négative du motif contenu sur ledit masque, et où le procédé comprend en outre les étapes de : enlèvement des parties non exposées dudit revêtement sensible à la lumière pour découvrir des parties du second matériau ; et gravure des parties de la surface avec un agent de gravure qui enlève ledit second matériau pour exposer ledit premier matériau sans enlever ledit revêtement sensible à la lumière restant ; et suivi par l'enlèvement dudit matériau restant sensible à la lumière.

5. Procédé selon la revendication 4 dans lequel ledit matériau sensible à la lumière comprend un photo-résist.

6. Procédé selon la revendication 2 comprenant en outre les étapes supplémentaires avant le balayage de : traduction dudit modèle d'ordinateur dans un support de commande de bande commandée numériquement pour une machine d'usinage commandée numériquement (31) ; et commande du balayage de ladite source lumineuse (33) à travers des informations de motif contenues sur ledit support de commande de bande de machine d'usinage pour exposer ladite surface cible dans l'image négative du motif définie par ledit support de commande de bande de machine d'usinage ; et comprenant en outre les étapes supplémentaires de :
enlèvement des parties non exposées dudit revêtement sensible à la lumière de ladite surface (21) pour exposer le matériau sous-jacent, et gravure des parties exposées de la surface à partir de laquelle le revêtement sensible de la lumière était enlevé avec un agent de gravure de métal pour enlever le second matériau sous-jacent et exposer le premier matériau et enlever le revêtement restant sensible à la lumière.

7. Procédé selon la revendication 1 comprenant en outre les étapes avant le balayage de : traduction des informations de motif telles que contenues dans ledit modèle d'ordinateur bidimensionnel sous la forme d'une bande de commande de machine d'usinage commandée numériquement, et placement de la surface dans la machine d'usinage (31) et dans lequel l'étape de balayage comprend l'application de la lumière de haute intensité capable (33) de vaporiser le métal pour vaporiser des zones dudit placage de métal dans le négatif de l'image du motif comme représenté par les informations contenues dans la bande de machine d'usinage.

8. Procédé de fabrication d'une surface réfléchissante RF dichroïque (37) du type contenant un réseau des éléments de rayonnement de dipôle de diaphonie de métal mince plat (39) d'une dimension substantiellement identique et de forme régulièrement espacée autour et fixée à une surface de forme parabolique convexe d'un matériau isolant électrique à partir d'un corps d'un matériau isolant ayant une surface de forme parabolique convexe qui comprend les étapes de toute revendication précédente.
